# FASCICULE DE BREVET EUROPEEN

(11) **EP 0 571 268 B1**
(45) Date de publication et mention de la délivrance du brevet: **29.07.1998**
(21) Numéro de dépôt: 93401270.9
(22) Date de dépôt: 18.05.1993
(51) Int. Cl.: H01L 31/147, H01L 31/153, H01L 25/16, H01L 27/15

(54) **Système de conversion d'une image infrarouge en image visible ou proche infrarouge**
System zur Umwandlung eines Infrarotbilds in ein Bild im sichtbaren oder nahen infraroten Bereich
System for the conversion of an infrared image in a visible or near infrared image

(30) Priorité: 21.05.1992 FR 9206209
(43) Date de publication de la demande: 24.11.1993
(73) Titulaire: COMMISSARIAT A L'ENERGIE ATOMIQUE, 75015 Paris (FR)
(72) Inventeur: Wolny, Michel, F-38000 Grenoble (FR); Amingual, Daniel, F-38000 Grenoble (FR)
(74) Mandataire: Dubois-Chabert, Guy

(56) Documents cités:
- EP-A- 0 371 868
- EP-A- 0 373 807
- US-A- 4 205 227
- INTERNATIONAL ELECTRON DEVICE MEETING 6 Décembre 1987, WASHINGTON, USA pages 225 - 228 O. WADA 'Planar structure optoelectronic integrated circuits: towards advanced optical processing and communication'
- IEEE TRANSACTIONS ON COMPONENTS,HYBRIDS,AND MANUFACTURING TECHNOLOGY vol. 13, no. 3, Septembre 1990, NEW YORK US K. HATADA ET AL. 'LED Array modules by new technology microbump bonding method'
- JOURNAL OF LIGHTWAVE TECHNOLOGY vol. LT-5, no. 10, Octobre 1987, NEW YORK US pages 1382 - 1390 H. MATSUEDA 'ALGAAS OEIC TRANSMITTERS'
- PROCEEDINGS OF THE IEEE vol. 75, no. 11, Novembre 1987, NEW YORK US pages 1488 - 1497 S. R. FORREST 'OPTOELECTRONIC INTEGRATED CIRCUITS'

## Description

La présente invention concerne un système de conversion d'une image infrarouge en image visible ou proche infrarouge.

Elle s'applique notamment à l'imagerie infrarouge, par exemple à la vision nocturne et à la vision dans des conditions atmosphériques difficiles (par temps de pluie ou dans le brouillard par exemple).

On connaît déjà des dispositifs permettant de réaliser de l'imagerie infrarouge dans les fenêtres de transmission atmosphérique (de 3 à 5 micromètres et de 8 à 12 micromètres).

Ces dispositifs ou caméras utilisent soit un détecteur à petit nombre de points élémentaires, la couverture de la scène étant assurée grâce à un balayage optomécanique, soit - pour les systèmes les plus avancés - une mosaïque détectrice à grand nombre de points (256x256 par exemple), ce qui supprime alors toute nécessité de balayage.

Dans le cas des systèmes récents dits "à mosaïque fixe", deux options technologiques peuvent être utilisées au niveau du détecteur :
- hybridation du détecteur sur son circuit de lecture (par l'intermédiaire de micro-billes d'indium par exemple),
- intégration monolithique, sur un substrat de silicium, du détecteur (qui est par exemple constitué d'une matrice de détecteurs Schottky PtSi) et de son circuit de lecture.

D'une manière générale, ces dispositifs connus, permettant de réaliser de l'imagerie infrarouge, se caractérisent :
- par une performance élevée mais aussi
- par un poids, un encombrement et une consommation importants.

Au sujet de ces dispositifs, on pourra consulter le livre suivant
(1) G. GAUSSORGUES, La Thermographie Infrarouge, éditions Lavoisier, Paris, 1984.

On connaît également des dispositifs de vision nocturne comportant des tubes intensificateurs de lumière.

Ces derniers ont pour but d'étendre le domaine de la vision humaine vers les bas niveaux de lumière, par une augmentation du spectre de sensibilité vers le proche infrarouge (longueurs d'ondes optiques inférieures à 1 micromètre) et par une amplification du niveau lumineux.

Ces dispositifs de vision nocturne connus utilisent généralement - pour les dispositifs de troisième génération qui sont les plus récents - une photocathode à base d'arséniure de gallium, une galette de micro-canaux et un écran luminescent disposé sur une fenêtre de fibres optiques.

Ces dispositifs de vision nocturne se caractérisent principalement par leur compacité et leur faible poids, ce qui autorise leur utilisation dans des jumelles de vision nocturne par exemple.

Cependant, les performances de ces dispositifs de vision nocturne restent limitées en raison du domaine spectral couvert par ces dispositifs.

Au sujet de tels dispositifs on pourra consulter le document suivant

(2) Article de M. Fouassier et al., intitulé "Tubes intensificateurs d'image de 3e génération" et publié dans Acta Electronica, vol.27, n°3 et 4, 1987 p.159 à 163.

En outre EP-A-0 373 807 décrit un dispositif de conversion d'une image infrarouge en une image visible comprenant des moyens optiques d'entrée, des moyens optiques de sortie, un détecteur infrarouge sur lequel est formée une image infrarouge d'une scène, par l'intermédiaire des moyens optiques d'entrée, un circuit de traitement des signaux fournis par le détecteur, un émetteur de lumière visible prévu pour fournir par l'intermédiaire des moyens optiques de sortie, ladite image sous forme de lumière visible à partir des signaux fournis par le circuit de traitement. L'émetteur de lumière visible ainsi que le circuit de traitement des signaux sont intégrés dans un substrat semiconducteur, le détecteur infrarouge étant formé par un film pyroélectrique maintenu au-dessus du substrat semiconducteur par des piliers.

La présente invention résout le probléme de l'obtention d'un système de conversion d'une image infrarouge en une image visible (directement exploitable par l'oeil humain) cu en une image du proche infrarouge, qui soit susceptible d'être rendu très compact et d'avoir un faible poids afin d'être facilement portable, ce système combinant au mieux les avantages respectifs des deux types de dispositifs mentionnés plus haut, à savoir :
- le haut niveau des performances offertes par l'imagerie dans l'infrarouge moyen (longueurs d'ondes optiques allant de 3 à 5 micromètres) et dans l'infrarouge lointain (longueurs d'ondes optiques allant de 8 à 12 micrométres),
- la compacité et le faible poids des équipements d'un tube intensificateur de lumière.

Pour résoudre ce problème, le système objet de l'invention, permettant la conversion d'une image infrarouge en image visible ou proche infrarouge et comportant :
- ces moyens optiques d'entrée,
- des moyens optiques de sortie,
- un détecteur infrarouge sur lequel est formée une image infrarouge d'une scène, par l'intermédiaire des moyens optiques d'entrée,
- un circuit de lecture des signaux fournis par ce détecteur,
- un circuit de traitement des signaux fournis par le circuit de lecture,
- un émetteur de lumière visible ou proche infrarouge, prévu pour fournir par l'intermédiaire des moyens optiques de sortie, ladite image sous forme de lumière visible ou proche infrarouge, à partir des signaux fournis par le circuit de traitement, et
- un circuit d'adressage de l'émetteur, qui est commandé par le circuit de traitement,
le système étant caractérisé en ce qu'il comprend un substrat semiconducteur dont une face constitue un plan focal commun aux moyens optiques d'entrée et aux moyens optiques de sortie et en ce que le détecteur, le circuit de lecture, le circuit de traitement, le circuit d'adressage et l'émetteur sont intégrés sur ladite face du substrat constituant ce plan focal.

Une caractéristique essentielle de la présente invention réside ainsi dans l'intégration, dans le plan focal du système, d'un émetteur de lumière et d'un détecteur infrarouge qui est relié à l'émetteur de lumière par l'intermédiaire de moyens électroniques adaptés.

Selon un mode de réalisation particulier du système objet de l'invention, le détecteur est une mosaïque de photodétecteurs infrarouge.

Selon un autre mode de réalisation particulier, ce détecteur est une barrette de photodétecteurs infrarouge et le système comprend en outre des moyens de balayage optique de cette barrette.

Selon un autre mode de réalisation particulier, l'émetteur est une mosaïque de photoémetteurs dans le domaine visible ou proche infrarouge.

Selon un autre mode de réalisation particulier, l'émetteur est une barrette de photoémetteurs dans le domaine visible ou proche infrarouge et le système comprend en outre des moyens de balayage optique de cette barrette.

Dans une réalisation particulière de l'invention, le détecteur est hybridé au circuit de lecture.

Dans une autre réalisation particulière, le détecteur et le circuit de lecture sont intégrés monolithiquement au substrat.

Dans une autre réalisation particulière, l'émetteur est hybridé au circuit d'adressage et cet émetteur est formé sur un substrat transparent à la lumière engendrée par cet émetteur.

Dans une autre réalisation particulière, l'émetteur est hybridé au circuit d'adressage, cet émetteur est formé sur un substrat qui est opaque à la lumière émise par cet émetteur et ce substrat opaque comporte des trous en regard des photoémetteurs dont est composé l'émetteur, ces trous permettant le passage de la lumière engendrée par cet émetteur.

Dans une autre réalisation particulière, l'émetteur et le circuit d'adressage sont intégrés monolithiquement au substrat.

Enfin, l'émetteur peut être apte à produire une lumière appartenant au domaine proche infrarouge, le système comprenant alors en outre des moyens de conversion de cette lumière en lumière visible.

On notera que la présente invention permet de réduire considérablement l'encombrement et le poids des systèmes d'imagerie thermique, fonctionnant dans l'infrarouge moyen et lointain.

De plus, le haut niveau d'intégration permis par la présente inventicn conduit à un accroissement de la fiabilité et à une réduction du coût par rapport aux systèmes d'imagerie infrarouge connus.

En outre, lorsqu'on a hybridé l'un des composants d'un système conforme à l'invention dans le plan focal de ce dernier, si ce composant est défectueux, son remplacement par un composant "sain" est envisageable.

La présente invention sera mieux comprise à la lecture de la description d'exemples de réalisation donnés ci-après à titre purement indicatif et nullement limitatif, en faisant référence aux dessins annexés sur lesquels :
- la figure 1 est une vue schématique d'un mode de réalisation particulier du système objet de l'invention,
- la figure 2 est une vue schématique et partielle du système représenté sur la figure 1,
- la figure 3 est une vue schématique et partielle d'un système conforme à l'invention, dans lequel le détecteur et le circuit de lecture de ce détecteur sont intégrés monolithiquement sur le substrat du système,
- la figure 4 est une vue en coupe schématique et partielle d'un système conforme à l'invention, dans lequel l'émetteur et le circuit d'adressage de ce dernier sont intégrés monolithiquement sur le substrat de ce système,
- la figure 5 est une vue de dessus partielle du système de la figure 4,
- la figure 6 est une vue schématique et partielle d'un autre système conforme à l'invention, dans lequel une mosaïque émettrice est intégrée monolithiquement au substrat du système,
- la figure 7 est une vue schématique et partielle d'un système conforme à l'invention, dans lequel l'émetteur est réalisé sur un substrat transparent à la lumière produite par cet émetteur, ce dernier étant hybridé à son circuit d'adressage,
- la figure 8 est une vue schématique et partielle d'un autre système conforme à l'invention, dans lequel l'émetteur est réalisé sur un substrat opaque à la lumière produite par cet émetteur,
- la figure 9 illustre schématiquement une structure épitaxiale utilisable dans la présente invention,
- la figure 10 illustre schématiquement et partiellement la structure obtenue après plusieurs étapes d'un procédé de réalisation d'un système conforme à l'invention, à partir de la structure représentée sur la figure 9,
- la figure 11 illustre schématiquement et partiellement la structure obtenue après la mise en oeuvre d'autres étapes de ce procédé,
- la figure 12 illustre schématiquement et partiellement la structure obtenue après la mise en oeuvre d'autres étapes dudit procédé, et
- la figure 13 est une vue schématique et partielle d'un système conforme à l'invention, utilisant une barrette détectrice et une barrette émettrice.

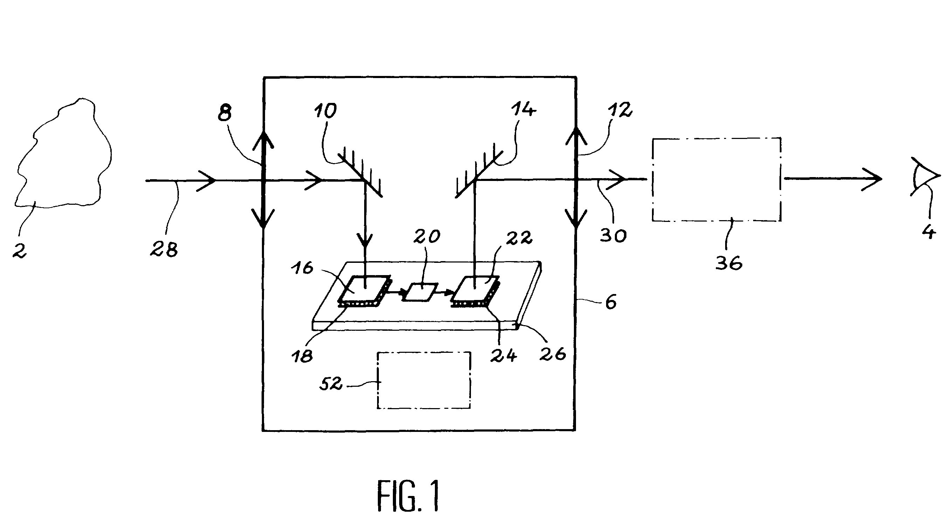

Sur la figure 1, on a représenté schématiquement un système conforme à l'invention, permettant de convertir l'image infrarouge d'une scène 2 observée par le système en une image visible directement exploitable par l'oeil d'un observateur 4.

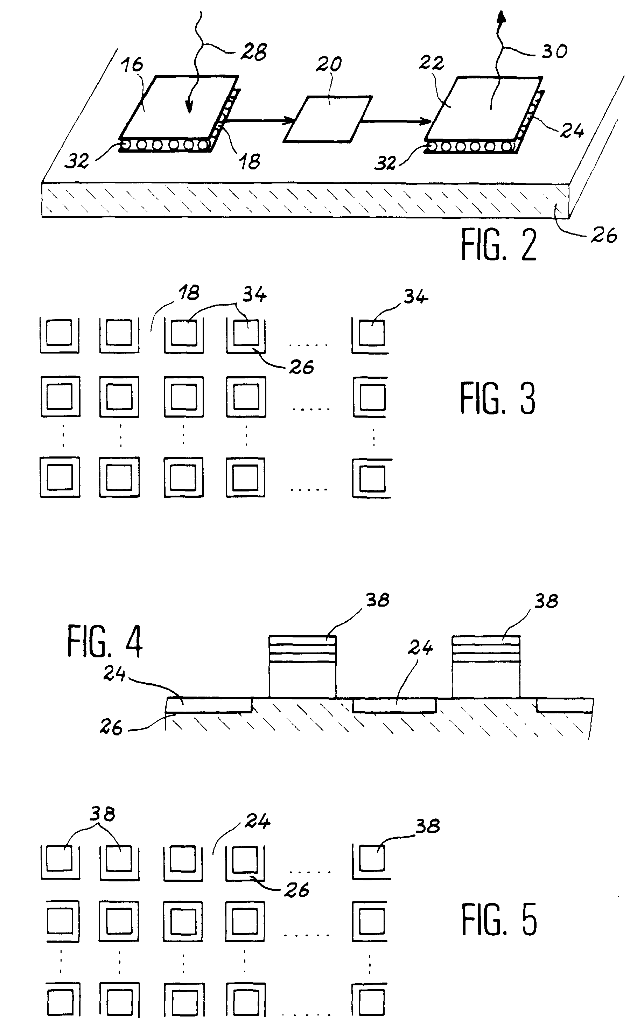

La figure 2 est une vue schématique et partielle d'une partie du système de la figure 1.

Ce système comprend, dans un boîtier 6 :
- des moyens optiques d'entrée constitués par une optique d'entrée 8 et un miroir 10 apte à réfléchir le rayonnement infrarouge,
- des moyens optiques de sortie constitués par une optique de sortie 12 et un miroir 14 apte à réfléchir le rayonnement visible,
- un détecteur 16 du rayonnement infrarouge sur lequel est formée une image infrarouge de la scène, par l'intermédiaire des moyens optiques d'entrée,
- un circuit 18 de lecture des signaux électriques fournis par ce détecteur 16,
- un circuit 20 de traitement des signaux électriques fournis par ce circuit de lecture 18,
- un émetteur 22 de lumière visible, prévu pour fournir, par l'intermédiaire des moyens optiques de sortie, ladite image sous forme de lumière visible, à partir des signaux électriques fournis par le circuit de traitement 20, et
- un circuit 24 d'adressage de l'émetteur 22, ce circuit d'adressage étant commandé par le circuit de traitement 20.

Le système représenté sur les figures 1 et 2 comprend aussi un substrat en silicium 26 dont une face constitue un plan focal commun aux moyens optiques d'entrée et aux moyens optiques de sortie.

Le détecteur 16, le circuit de lecture 18, le circuit de traitement 20, le circuit d'adressage 24 et l'émetteur 22 sont intégrés dans ce plan focal, sur cette face du substrat 26.

Le rayonnement infrarouge 28, qui est issu de la scène 2 (paysage ou objet par exemple), traverse l'optique d'entrée 8 puis se réfléchit sur le miroir 10 pour être focalisé sur le détecteur 16 grâce à l'optique 8 prévue à cet effet.

L'image infrarouge de la scéne 2, qui est ainsi obtenue et détectée, est ensuite lue par le circuit de lecture 18, traitée par le circuit de traitement 20 et enfin convertie en une image visible directement observable par l'oeil de l'observateur 4 grâce à l'émetteur 22 et à l'optique de sortie 12 à laquelle parvient la lumière visible 30 émise par l'émetteur 22 après réflexion sur le miroir 14.

Le détecteur 16 se présente sous la forme d'une mosaïque de nxm photodétecteurs élémentaires, où n et m sont des nombres entiers qui sont par exemple tous deux égaux à 128.

Les photodétecteurs élémentaires sont tous du même type et, à titre purement indicatif et nullement limitatif, peuvent être choisis dans la liste suivante pour des longueurs d'onde allant de 3 à 5 micromètres et/ou de 8 à 12 micromètres :
- photoconducteurs P/N sur Hg₁₋ₓCdₓTe ou encore sur In₁₋ₓAsₓSb,
- photodiodes à multipuits quantiques (par exemple GaAs/Ga₁₋ₓAlₓAs),
- photodiodes fondées sur la photo-émission interne au-dessus d'une barrière de potentiel (PtSi/Si, IrSi/Si, Si₁₋ₓGeₓ/Si par exemple),
- détecteurs pyroélectriques minéraux ou polymères (poly-vinyl-difluoré ou tantalate de lithium par exemple).

Dans l'exemple représente sur la figure 2, la mosaïque de détection infrarouge 16 est hybridée (par l'intermédiaire de micro-billes d'indium 32 par exemple) à son circuit de lecture 18 qui est réalisé sur le substrat en silicium 26.

Dans un autre mode de réalisation du système, qui est schématiquement et partiellement représenté sur la figure 3, la mosaïque de détection infrarouge 16, comportant une pluralité de photodétecteurs infrarouges élémentaires 34, et son circuit de lecture 18 sont intégrés de façon monolithique sur le substrat de silicium 26.

Les divers procédés de fabrication de tels détecteurs infrarouges sont bien connus de l'homme de l'art.

A ce sujet, on consultera par exemple le document suivant :
(3) Article de P.R. Norton, intitulé "Infrared image sensors" et publié dans Optical Engineering, Novembre 1991, vol.30, n°11, p.1649 à 1663.

L'émetteur de lumière 22 se présente sous la forme d'une mosaïque de pxq photo-émetteurs élémentaires, où p est inférieur ou égal à n et q inférieur ou égal à m, avec de préférence p=n et q=m.

On peut ainsi associer à chaque pixel ou groupe de pixels de la mosaïque de détection 16 un point élémentaire de la mosaïque d'émission 22.

Comme on l'a vu, la longueur d'onde de la lumière émise se situe dans le spectre visible.

Cependant, on pourrait utiliser un émetteur produisant une lumière du domaine proche infrarouge, c'est-à-dire dont la longueur d'onde est inférieure à 1 micromètre.

Dans ce cas, un dispositif 36, analogue à ceux qui sont utilisés dans les systèmes à tubes amplificateurs de lumière, est ajouté au système (voir la figure 1) pour transformer l'image émise dans le proche infrarouge en une image visible par l'observateur 4.

Comme on le voit sur la figure 2, la mosaïque émettrice 22 peut être hybridée sur son circuit d'adressage 24 réalisé sur le substrat de silicium 26, par une technique analogue à celle utilisée pour l'hybridation de la mosaïque de détection sur son circuit de lecture.

Dans un autre mode de réalisation particulier, cette mosaïque émettrice 22, comportant une pluralité de photo-émetteurs élémentaires 38, est intégrée avec son circuit d'adressage 24 de manière monolithique sur le substrat de silicium 26.

Cette intégration monolithique est illustrée par la figure 4 qui est une vue en coupe schématique et partielle du système conforme à l'invention dans lequel cette intégration monolithique est utilisée, et par la figure 5 qui est une vue de dessus schématique et partielle de ce système.

Les photo-émetteurs élémentaires (points élémentaires) de la mosaïque d'émission 22 peuvent être soit des diodes électroluminescentes (par exemple des diodes (Ga_{1-y}Al_{y})₁₋ₓInₓP, Ga₁₋ₓAsₓP pour une émission dans le domaine visible ou des diodes GaAs/Ga₁₋ₓAlₓAs pour une émission dans le domaine du proche infrarouge) soit des diodes lasers à cavités verticales (par exemple GaAs/Ga₁₋ₓAlₓAs).

La croissance de GaAs sur le silicium par épitaxie est bien connue de l'homme de l'art de même que celle de (Ga_{1-y}Al_{y})₁₋ₓInₓP, GaAlAs/GaAs sur GaAs.

Les techniques de fabrication de chacun de ces composants émetteurs sont abondamment décrites dans la littérature.

On pourra consulter à ce sujet les documents suivants :
(4) Article de S.F. Fang et al., intitulé "Callium arsenide and other compound semiconductors on silicon" et publié dans J. Appl. Phys., vol.68, n°7, 1 octobre 1990, p.R31 à R58.
(5) Article de M. Mpaskoutas et al., intitulé "Uniformity-optical properties of GaInP-GaAlInP layers grown by MOVPE" et publié dans Journal of Crystal Growth 107 (1991) p.192 à 197.
(6) Article de H. Sugawara et al., publié dans Appl. Phys. Lett., vol.58, n°10, 11 mars 1991, p.1010 à 1012.

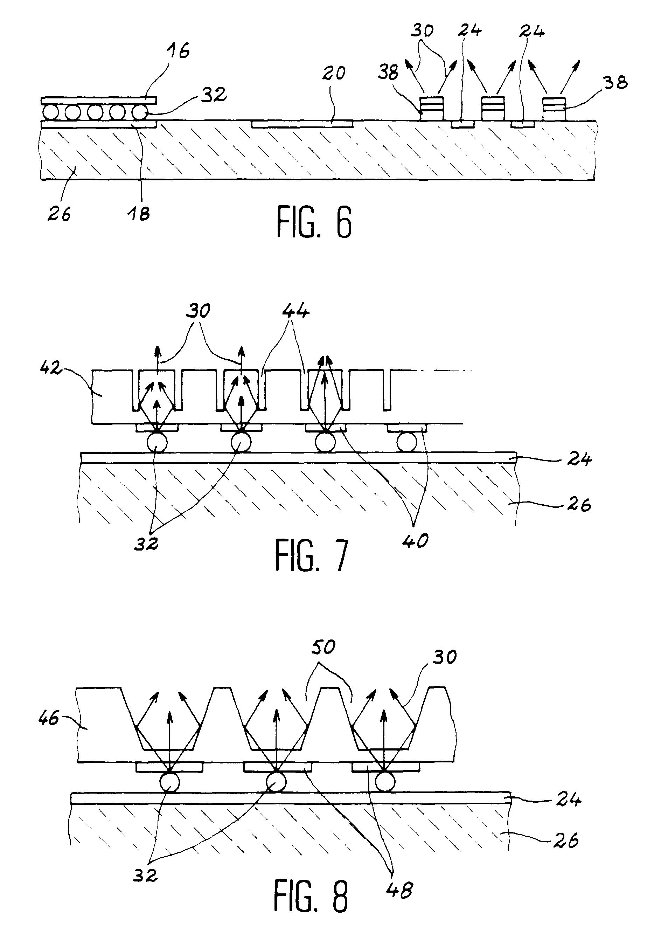

Lorsque la mosaïque émettrice est implantée de manière monolithique sur le substrat de silicium 26 qui porte son circuit d'adressage, l'émission de lumière (visible ou du proche infrarouge) peut alors se faire par la face avant de l'émetteur comme on le voit sur la figure 6.

Dans ce cas, le circuit d'adressage 24 se trouve entre les photo-émetteurs élémentaires 38 (pixels), ce qui est illustré par les figures 4 et 5.

Lorsque la mosaïque émettrice 22 est hybridée sur son circuit d'adressage 24, l'émission de lumière se fait alors par la face arrière de l'émetteur 22.

Il faut alors distinguer deux cas.

Dans le premier cas, le substrat sur lequel les photo-émetteurs élémentaires sont réalisés est transparent à la longueur d'onde de la lumière émise.

C'est le cas des substrats GaP sur lesquels sont réalisées des diodes électroluminescentes Ga₁₋ₓAsₓP (éventuellement (Ga_{1-y}Al_{y})₁₋ₓInₓP) émettant dans le domaine visible.

A ce sujet on se réfèrera au document suivant :
(7) Article de L.J. Stinson et al., intitulé "High-efficency InGaP light-emitting diodes on GaP substrates" et publié dans Appl. Phys. Lett., vol.58, n°18, 6 mai 1991, p.2012 à 2014.

Ce peut être aussi le cas des substrats GaAs lorsque les photo-émetteurs de lumière utilisés émettent dans le proche infrarouge.

Mais alors un dispositif du type intensificateur de lumière doit être ajouté au système, comme on l'a vu.

Dans ce premier cas, dont un exemple est schématiquement et partiellement représenté sur la figure 7, si les photo-émetteurs de lumière élémentaires sont des diodes électroluminescentes 40, il est préferable que le substrat 42, sur lequel sont formées ces diodes 40 et qui est transparent à la lumière émise par celles-ci, soit réticulé afin de limiter fortement les risques d'inter-modulation entre pixels (correspondant à ces diodes).

Comme on le voit sur la figure 7, une telle configuration est obtenue grâce à des rainures 44 qui sont formées dans le substrat 42 et qui séparent les diodes 40 les unes des autres.

Avec des diodes lasers à émission verticale on n'a pas besoin d'un tel traitement du substrat du fait de la forte directivité des faisceaux lumineux émis par ces diodes lasers verticales, dont le procédé de fabrication est cependant plus délicat que le procédé de fabrication des diodes électroluminescentes mentionnées plus haut.

Dans le deuxième cas, le substrat sur lequel les photo-émetteurs élémentaires sont réalisés n'est pas transparent à la longueur d'onde de la lumière émise (dans le visible) par ces photo-émetteurs élémentaires.

C'est le cas de la majeure partie des substrats couramment utilisés en micro-électronique (Si, Ge, InP, GaAs).

Parmi tous ces substrats, l'arséniure de gallium est le meilleur candidat pour l'application envisagée ici : on sait en effet réaliser par épitaxie sur GaAs divers matériaux permettant la fabrication de composants qui émettent dans le domaine visible (par exemple GaAlInP).

La figure 8 illustre schématiquement et partiellement ce deuxième cas.

On voit sur cette figure 8 le substrat 46 sur lequel est formée la mosaïque émettrice constituée de diodes électroluminescentes 48 qui émettent une lumière à laquelle le substrat 46 est opaque, cette mosaïque émettrice étant hybridée à son circuit de lecture 24 comme précédemment, à l'aide de billes d'interconnexion 32.

Pour éviter la ré-absorption, dans ce substrat 46, de la lumière émise par les diodes 48, ce substrat 46 est tout d'abord aminci, typiquement à une épaisseur de 50 à 100 micromètres, puis des trous 50 sont réalisés à l'aplomb des diodes émettrices afin de libérer une voie de passage pour la lumière 30 émise.

De cette façon, l'intermodulation entre pixels est "naturellement" très faible.

Les techniques d'épitaxie de GaAlInP sur GaAs ont fait l'objet de nombreuses publications.

A ce sujet, on pourra consulter les documents (5) et (6).

Le procédé d'hybridation de la mosaïque d'émission sur son circuit d'adressage est le même que le procedé utilisé pour hybrider la mosaïque de détection infrarouge sur son circuit de lecture.

Un mode de réalisation de cette hybridation est décrit dans le document suivant :
(8) Demande de brevet français n° 89 05542 du 26 avril 1989 (voir aussi le document EP-A-0 395 488).

La réalisation de trous tels que les trous 50 dans le substrat 46 en GaAs sera décrite plus loin.

Les techniques utilisées sont celles de la micro-électronique.

On revient maintenant sur les circuits électroniques utilisés dans le système qui a été décrit en faisant référence aux figures 1 à 8.

Le circuit 18 de lecture de la mosaïque détectrice 16 (qui est par exemple un circuit CCD ou CMOS) lit et multiplexe les signaux issus de chacun des photodétecteurs élémentaires composant cette mosaïque.

Le circuit 24 d'adressage de l'émetteur, ou plus exactement le circuit de démultiplexage/adressage, permet d'associer à chaque pixel ou à chaque groupe de pixels du détecteur un pixel de l'émetteur.

Le circuit de traitement 20 comprend un ou plusieurs sous-circuits de traitement du signal (par exemple pour effectuer des corrections de gain et des corrections de décalage "offsets" pour compenser les non-uniformité des pixels du détecteur), et comprend aussi un amplificateur qui permet d'amener le signal sortant du circuit de lecture et du ou des sous-circuits de traitement à des niveaux susceptibles d'assurer une polarisation correcte des photo-émetteurs élémentaires.

Le circuit de lecture et le circuit d'adressage sont formés sur le substrat de silicium 26.

Le circuit de traitement 20 est également formé sur le substrat 26.

Certaines fonctions du ou des sous-circuits de traitement peuvent être directement intégrées dans le circuit de lecture du détecteur, au niveau de chaque photo-détecteur élémentaire.

Cependant, certains éléments du circuit de traitement 20 pourraient être hybridés sur le substrat de silicium 26.

Les circuits de lecture, de démultiplexage/adressage et de traitement sont bien connus quant à leur principe et à leur mode de réalisation et l'on ne donnera pas plus de détail ici à leur sujet.

L'ajout d'une mosaïque émettrice dans le plan focal commun aux moyens optiques d'entrée et aux moyens optiques de sortie n'augmente pas considérablement la puissance dissipée dans ce plan focal, qui est typiquement de l'ordre de 50 à 100 mW pour une mosaïque de 128x128 photodiodes en HgCdTe.

En effet, compte tenu du temps d'intégration de l'oeil, on peut se permettre d'activer les pixels émetteurs les uns après les autres.

A titre d'exemple, si la mosaïque émettrice est une mosaïque comportant 128x128 photo-émetteurs élémentaires, il suffit pour ce faire d'utiliser des circuits électroniques au silicium dont la bande passante est de l'ordre de 1 MHz.

Dans ce cas, la consommation globale dans le plan focal n'augmente donc que de quelques mW.

Si le détecteur infrarouge utilisé nécessite un refroidissement à 77 K, on peut alors utiliser un refroidisseur 52 (voir figure 1) fonctionnant selon un cycle de Stirling.

Certains de ces refroidisseurs sont aujourd'hui très compacts, ont un faible poids et consomment peu d'énergie.

Si le détecteur infrarouge est apte à fonctionner à 200 K (par exemple cas des matrices HgCdTe dans le domaine de longueurs d'ondes allant de 3 à 5 micromètres), un refroidissement par modules de thermo-éléments est envisageable.

Enfin, certains détecteurs infrarouges (les détecteurs pyroélectriques par exemple) ne nécessitent aucun refroidissement.

Une manière de réaliser une matrice de tels détecteurs pyroélectriques de façon monolithique sur un substrat de silicium est décrite dans le document suivant :
(9) demande de brevet français n° 88 155 81 du 29 novembre 1988 (voir aussi EP-A-0 371 868 et US-A-5 008541).

Il faut bien noter que seul le détecteur infrarouge nécessite un refroidissement.

Par conséquent, la mosaïque émettrice peut se trouver à une température légèrement supérieure à celle du détecteur infrarouge sans pour cela altérer le fonctionnement du système.

Ceci permet éventuellement de limiter la taille du doigt froid du refroidisseur fonctionnant selon le cycle de Stirling.

La réalisation du système objet de l'invention fait appel à de nombreuses techniques bien connues qui ne seront donc pas détaillées ici.

Des références bibliographiques ont déjà été fournies pour donner des indications sur la réalisation des éléments de ce système.

On donne ci-après, à titre purement indicatif et nullement limitatif, des exemples de réalisation de certains de ces éléments.

A titre d'exemple, le détecteur infrarouge est une mosaïque PtSi comportant 64x64 pixels, la taille élémentaire de chaque pixel étant égale à 30 micromètres x 30 micromètres.

Ce détecteur infrarouge est hybridé sur un circuit de lecture CMOS et il est refroidi à 77 K.

A ce sujet, on pourra se référer au document suivant :
(10) Article de W. Kosonocky , intitulé "Review of Schottky-barrier imager technology" et publié dans SPIE, vol.1308 Infrared Detectors and Focal Plane Arrays (1990) p.2 à 26.

Le détecteur infrarouge est hybridé sur son circuit de lecture par la technique décrite dans le document (8).

Les détecteurs PtSi étant très uniformes, aucun circuit de correction complexe n'est utilisé dans cet exemple.

A titre d'exemple, la mosaïque émettrice comporte 64x64 eléments qui sont des diodes GaAlInP é lectroluminescentes émettant dans le domaine visible, réalisées sur un substrat en arsénium de gallium.

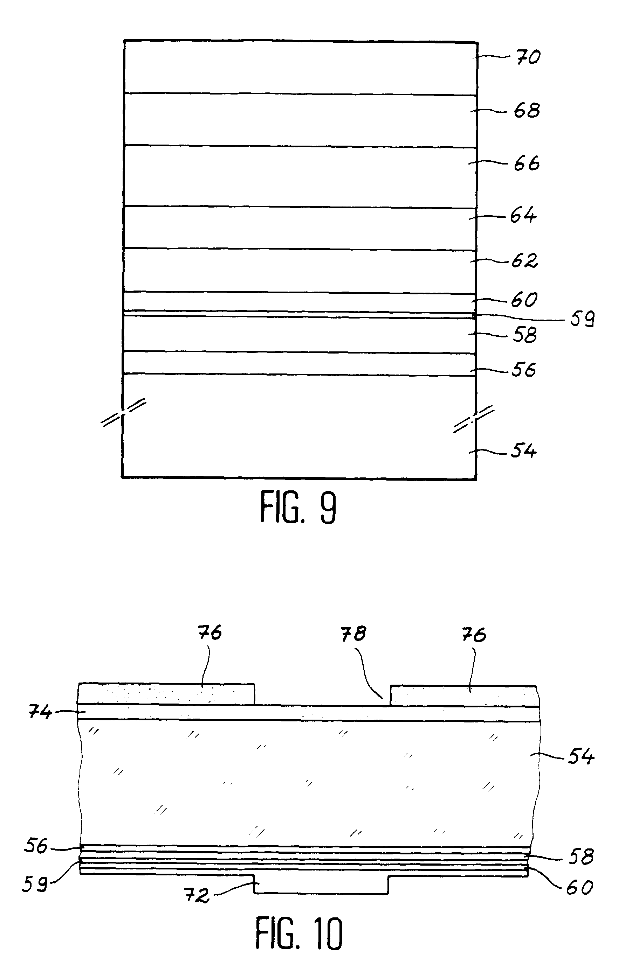

Cette mosaïque émettrice est réalisée à partir de la structure épitaxiale suivante (voir la figure 9) :
- un substrat 54 en GaAs dopé N⁺, d'épaisseur 500 micromètres,
- une couche 56 en GaAs, d'épaisseur 0,5 micromètre, dopée N avec N = 10¹⁸ cm⁻³,
- une couche 58 en Ga₁₋ₓAlₓAs dont l'épaisseur vaut 1 micromètre et qui est dopée N, avec N = 10¹⁸ cm⁻³ et x≥ 0,5,
- une couche 59 en Ga₁₋ₓAlₓAs avec x≥0,7 dont l'épaisseur vaut 3 nanomètres et qui est dopée N, avec N=10¹⁸ cm⁻³,
- une couche 60 en GaAs d'épaisseur 0,01 micromètre, dopée N avec N=10¹⁸ cm⁻³,
- une couche 62 en (Ga_{0,3}Al_{0,7})_{0,5}In_{0,5}P dont l'épaisseur est égale à 1 micromètre et qui est dopée N avec N=10¹⁸ cm³,
- une couche 64 en (Ga₁₋ₓAlₓ)_{0,5}In_{0,5}P dont l'épaisseur est égale à 0,6 micromètre et qui est non dopée, avec x≤0,2,
- une couche 66 en (Ga_{0,3}Al_{0,7})_{0,5}In_{0,5}P dont l'épaisseur est égale à 1 micromètre et qui est dopée P, avec P=3x10¹⁷ cm⁻³,
- une couche 68 en Ga_{0,3}Al_{0,7}As dont l'épaisseur est égale à 7 micromètres et qui est dopée P, avec P=3x10¹⁸cm⁻³, et
- une couche 70 en GaAs d'épaisseur 2 micromètres, dopée P, avec P=3x10¹⁸ cm⁻³.

Comme on le voit sur la figure 9, ces couches 56 à 70 sont empilées dans cet ordre sur le substrat 54.

Cette structure épitaxiale est realisée par épitaxie en phase vapeur aux organo-métalliques mais d'autres techniques pourraient être utilisées.

La faisabilité des couches 56, 58, 59 et 60 est plus que largement démontrée.

Par ailleurs, le document (6) établit la faisabilité de l'empilement des couches 62 à 70.

De plus, le document (5) présente une méthode d'élaboration permettant de réaliser des couches de GaAlInP sur GaAs (la couche 60 jouant à cet effet le rôle du substrat) de manière très homogène.

On précise ci-après le rôle des diverses couches.

La couche 56 est une couche-tampon permettant d'assurer une épitaxie des couches 58 et 60 de grande qualité.

Les couches 58 et 59 permettent d'avoir des attaques sélectives de GaAs par rapport à GaAlAs de manière simple (attaque chimique ou gravure ionique réactive).

La couche 59 est transparente à la lumière émise (voir le document (6).

La couche 60 permet de démarrer la croissance du reste de la structure sur du GaAs.

Cette couche 60 est d'épaisseur suffisamment faible pour n'absorber qu'une très faible partie de la lumière émise.

Les couches 62 à 70 permettent la fabrication d'une jonction P/N à la base de la réalisation des diodes électroluminescentes.

A ce sujet, on consultera le document (6).

On indique ci-après comment réaliser et hybrider la mosaïque émettrice.

Etape 1: on réalise la structure épitaxiale qui vient d'être décrite en faisant référence à la figure 9.

Etape 2 : on réalise les diodes électroluminescentes.

La faisabilité de ces diodes électroluminescentes est démontrée dans le document (6).

Il est à souligner que, pour assurer la compatibilité du procédé décrit dans ce document (6) avec l'étape d'hybridation, le composant obtenu, portant les diodes, est ensuite passivé, par exemple à l'aide d'une couche de polyimide.

Le contact électrique du substrat est assuré par un simple fil électrique soudé sur la face arrière du composant, le substrat conducteur permettant d'utiliser un contact commun pour toute la mosaïque de diodes émettrices.

La taille d'une diode électroluminescente est par exemple de 75 micromètres x 75 micromètres.

La mosaïque émettrice comporte 64x64 diodes élémentaires au pas de 200 micromètres par exemple.

Etape 3 : le substrat est aminci par des moyens mécaniques ou chimiques classiques jusqu'à une centaine de micromètres.

Etape 4 : on dépose une couche protectrice résistant à l'abrasion (ionique ou réactive).

Pour ce faire, on dépose par exemple une couche mince d'alumine au moyen d'un canon à électrons.

Etape 5 : dépôt d'une couche de résine photosensible.

Etape 6 : on positionne par alignement double face des ouvertures à graver en face des diodes émettrices.

Il existe plusieurs procédés de positionnement double face.

Par exemple, sur une machine normale, on positionnera les émetteurs par rapport à un réticule, l'ensemble sera bloqué en position, retourné, puis on alignera les trous sur des repères placés à l'extérieur du réticule.

Etape 7 : insolation et ouverture de la résine photosensible (procédé classique).

La figure 10 illustre schématiquement et partiellement la structure obtenue après les étapes 1 à 7.

On voit sur cette figure 10 le substrat 54 qui a été aminci et qui porte les couches 56, 58, 59, 60 et les diodes telles que la diode 72 sur sa face supérieure (qui est orientée vers le bas de la figure 10, contrairement à la figure 9).

On voit aussi sur la figure 10 la couche protectrice 74 en alumine, déposée sur la face inférieure du substrat 54 ainsi que la couche de résine 76 qui a été déposée sur la couche d'alumine 74 et dans laquelle on a réalisé des ouvertures, telles que l'ouverture 78, en regard des diodes électroluminescentes, telles que la diode 72.

Etape 8 : gravure de la couche protectrice, par voie chimique.

Une solution d'attaque de l'alumine est la suivante :
H₃PO₄ + alcool isopropylique à 80°C ou bien H₂SO₄ à 10% à 40 ou 60°C.

Etape 9 : usinage ionique ou usinage ionique réactif des trous dans le substrat jusqu'à une épaisseur d'environ 50 micromètres.

Etape 10 : hybridation sur le circuit d'adressage par un procédé analogue à celui qui est utilisé pour hybrider la mosaïque de détection - voir le document (8).

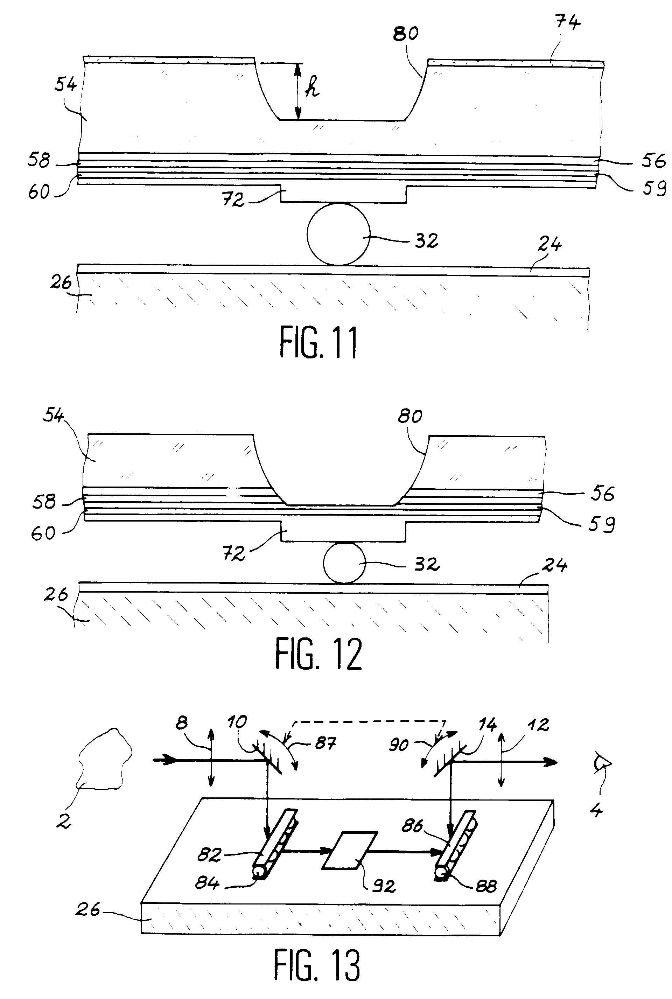

La figure 11 montre schématiquement et partiellement la structure obtenue après les étapes 1 à 10.

On voit sur cette figure 11 le substrat en silicium 26 portant le circuit d'adressage 24.

On voit aussi le substrat 54 portant les diodes, telles que la diode 72, hybridées par des billes d'indium telles que la bille 32, au circuit d'adressage 24.

On voit aussi les trous, tels que le trou 80, qui ont été formés dans le substrat aminci 54 par la face arrière de celui-ci en regard des diodes électroluminescentes, telles que la diode 72, et dont la profondeur h est de l'ordre de 50 micromètres.

On voit aussi le reste de la couche d'alumine 74.

Etape 11 : protection des circuits présents dans le plan focal par une couche de résine photosensible et ouverture de cette couche de résine photosensible sur la face arrière de la mosaïque émettrice (un alignement approximatif - macroscopique - étant suffisant).

Etape 12 : étape identique à l'étape 8 si la couche d'alumine n'a pas totalement disparu lors de l'usinage ionique.

Etape 13 : attaque chimique ou attaque ionique réactive de GaAs sélective par rapport à la couche 58.

Un exemple de bain sélectif est donné dans le document suivant :

Article de T. KOBAYASHI et al., publié dans Japan J. Appl. Phys., vol.12, 1973, n°4, p.619 à 620.

Puis les couches 58, 59 sont attaquées chimiquement sur une profondeur de 1,5 micromètre par un bain qui peut être par exemple le bain suivant :

NH₄OH/H₂O₂/H₂O.

A la fin de cette attaque, seule subsiste une partie de la couche 60 d'épaisseur suffisamment fine pour n'absorber qu'une très faible partie de la lumière émise.

Etape 14 : retrait de la couche de résine protégeant le plan focal et déposée à l'étape 11.

La figure 12 illustre de façon schématique et partielle la structure obtenue après l'étape 14.

Il est à noter que l'hybridation de la mosaïque détectrice ne se fait qu'après celle de la mosaïque émettrice, c'est-à-dire après l'étape 14 décrite ci-dessus.

Dans un autre système conforme à l'invention, la mosaïque détectrice 16 est remplacée par une simple barrette de détecteurs infrarouges élémentaires 82 comme le montre la figure 13.

On voit aussi sur cette figure 13 le circuit 84 de lecture de cette barrette 82.

Dans ce cas, le miroir 10, placé au-dessus de la barrette 82, est muni de moyens 87 qui sont représentés par une double flèche courbe sur la figure 13 et qui sont prévus pour balayer la barrette 82 avec le faisceau infrarouge issu de la scène 2, de manière à former ligne par ligne l'image infrarouge de la scène 2 sur la barrette 82 qui détecte donc encore cette image infrarouge.

De même, comme on le voit aussi sur la figure 13, la mosaïque émettrice 22 peut être remplacée par une simple barrette d'émetteurs de lumière visible ou proche infrarouge 86 dont le circuit de multiplexage/adressage porte la référence 88 sur la figure 13.

Dans ce cas, le miroir 14 qui est disposé en face de cette barrette émettrice 86, est muni de moyens 90 qui sont symbolisés par une double flèche courbe sur la figure 13 et qui permettent au miroir de balayer la barrette 86 de manière à former ligne par ligne l'image visible ou proche infrarouge.

Les moyens 87 et 90 sont couplés de façon à assurer la correspondance entre l'image de sortie et l'image infrarouge.

Le circuit de traitement utilisé dans le système de la figure 13 porte la référence 92.

## Revendications

1. Système de conversion d'une image infrarouge en image visible ou proche infrarouge, ce système comportant :
- des moyens optiques d'entrée (8, 10),
- des moyens optiques de sortie (12, 14),
- un détecteur infrarouge (16, 82) sur lequel est formée une image infrarouge d'une scène, par l'intermédiaire des moyens optiques d'entrée,
- un circuit (18, 84) de lecture des signaux fournis par ce détecteur,
- un circuit (20, 92) de traitement des signaux fournis par le circuit de lecture,
- un émetteur (22, 86) de lumière visible ou proche infrarouge, prévu pour fournir, par l'intermédiaire des moyens optiques de sortie, ladite image sous forme de lumière visible ou proche infrarouge, à partir des signaux fournis par le circuit de traitement, et
- un circuit (24, 88) d'adressage de l'émetteur, qui est commandé par le circuit de traitement,
le système étant caractérisé en ce qu'il comprend un substrat semiconducteur (26) dont une face constitue un plan focal commun aux moyens optiques d'entrée (8, 10) et aux moyens optiques de sortie (12, 14) et en ce que le détecteur, le circuit de lecture, le circuit de traitement, le circuit d'adressage et l'émetteur sont intégrés sur ladite face du substrat constituant ce plan focal.

2. Système selon la revendication 1, caractérisé en ce que le détecteur est une mosaïque (16) de photodétecteurs infrarouges.

3. Système selon la revendication 1, caractérisé en ce que le détecteur est une barrette (82) de photodétecteurs infrarouges et en ce que le système comprend en outre des moyens (87) de balayage optique de cette barrette.

4. Système selon l'une quelconque des revendications 1 à 3, caractérisé en ce que l'émetteur est une mosaïque (22) de photoémetteurs dans le domaine visible ou proche infrarouge.

5. Système selon l'une quelconque des revendications 1 à 3, caractérisé en ce que l'émetteur est une barrette (86) de photoémetteurs dans le domaine visible ou proche infrarouge et en ce que le système comprend en outre des moyens (90) de balayage optique de cette barrette.

6. Système selon l'une quelconque des revendications 1 à 5, caractérisé en ce que le détecteur (16) est hybridé au circuit de lecture (18).

7. Système selon l'une quelconque des revendications 1 à 5, caractérisé en ce que le détecteur (16) et le circuit de lecture (18) sont intégrés monolithiquement au substrat (26).

8. Système selon l'une quelconque des revendications 1 à 7, caractérisé en ce que l'émetteur (22) est hybridé au circuit d'adressage (24) et en ce que cet émetteur est formé sur un substrat (42) transparent à la lumière engendrée par cet émetteur.

9. Système selon l'une quelconque des revendications 1 à 7, caractérisé en ce que l'émetteur (22) est hybridé au circuit d'adressage (24), en ce que cet émetteur est formé sur un substrat (46) qui est opaque à la lumière émise par cet émetteur et en ce que ce substrat opaque comporte des trous (50) en regard des photoémetteurs dont est composé l'émetteur, ces trous permettant le passage de la lumière engendrée par cet émetteur.

10. Système selon l'une quelconque des revendications 1 à 7, caractérisé en ce que l'émetteur (22) et le circuit d'adressage (24) sont intégrés monolithiquement au substrat (26).

11. Sytème selon l'une quelconque des revendications 1 à 10, caractérisé en ce que l'émetteur (22, 86) est apte à produire une lumière appartenant au domaine proche infrarouge et en ce que le système comprend en outre des moyens (36) de conversion de cette lumière en lumière visible.

## Claims

1. System for the conversion of an infrared image into a visible or near infrared image, said system incorporating optical input means (8, 10), optical output means (12, 14), an infrared detector (16, 82) on which is formed an infrared image of a scene, by means of the optical input means, a circuit (18, 84) for reading the signals supplied by said detector, a circuit for processing the signals supplied by said reading circuit, a near infrared or visible light emitter (22, 86) for supplying, by means of the optical output means, said image in the form of visible or near infrared light, from signals supplied by the processing circuit and a circuit (24, 88) for addressing the emitter and which is controlled by the processing circuit, said system being characterized in that it also comprises a semiconductor substrate (26), whereof one face constitutes a focal plane common to the optical input means (8, 10) and optical output means (12, 14) and in that the detector, the reading circuit, the processing circuit, the addressing circuit and the emitter are integrated on said face of the substrate constituting said focal plane.

2. System according to claim 1, characterized in that the detector is a mosaic (16) of infrared photodetectors.

3. System according to claim 1, characterized in that the detector is an array (82) of infrared photodetectors and in that the system also comprises means (87) for the optical scanning of said array.

4. System according to any one of the claims 1 to 3, characterized in that the emitter is a mosaic (22) of photoemitters in the visible or near infrared range.

5. System according to any one of the claims 1 to 3, characterized in that the emitter is an array (86) of photoemitters in the visible or near infrared range and in that the system also comprises means (90) for the optical scanning of said array.

6. System according to any one of the claims 1 to 5, characterized in that the detector (16) is hybridized with the reading circuit (18).

7. System according to any one of the claims 1 to 5, characterized in that the detector (16) and the reading circuit (18) are monolithically integrated with the substrate (26).

8. System according to any one of the claims 1 to 7, characterized in that the emitter (22) is hybridized with the addressing circuit (24) and in that said emitter is formed on a substrate (42) transparent to the light produced by said emitter.

9. System according to any one of the claims 1 to 7, characterized in that the emitter (22) is hybridized with the addressing circuit (24), that said emitter is formed on a substrate (46) which is opaque to the light emitted by said emitter and that said opaque substrate has holes (50) facing the photoemitters from which the emitter is formed, said holes permitting the passage of the light produced by said emitter.

10. System according to any one of the claims 1 to 7, characterized in that the emitter (22) and addressing circuit (24) are monolithically integrated with the substrate (26).

11. System according to any one of the claims 1 to 10, characterized in that the emitter (22, 86) is able to produce a light belonging to the near infrared range and that the system also comprises means (36) for converting said light into visible light.

## Patentansprüche

1. System zur Umwandlung eines Infratrotbilds in ein Bild im sichtbaren oder nahen infraroten Bereich, umfassend:
- optische Eintrittseinrichtungen (8, 10)
- optische Austrittseinrichtungen (12, 14),
- einen Infrarot-Detektor (16, 82), auf dem durch die optischen Eintrittseinrichtungen ein Infrarotbild einer Szene abgebildet wird,
- eine Leseschaltung (18, 84) der durch diesen Detektor gelieferten Signale,
- eine Verarbeitungschaltung (20, 92) der durch diese Leseschaltung gelieferten Signale,
- einen Sender (22, 86) von sichtbarem oder nahem infraroten Licht, dazu vorgesehen, mittels der optischen Ausgangseinrichtungen das genannte Bild in Form von sichtbarem oder nahem infraroten Licht aufgrund von durch die Verarbeitungsschaltung gelieferten Signalen zu liefern, und
- eine Schaltung (24, 88) zur Adressierung des Senders, die durch die Verarbeitungsschaltung gesteuert wird,
**dadurch gekennzeichnet**,
daß es ein Halbleitersubstrat (26) umfaßt, von dem eine Fläche eine gemeinsame Fokalebene für die optischen Eintrittseinrichtungen (8, 10) und die optischen Austrittseinrichtungen (12, 14) bildet, und dadurch, daß der Detektor, die Leseschaltung, die Verarbeitungsschaltung, die Adressierungsschaltung und der Sender auf der genannten, diese Fokalebene bildenden Fläche des Substrats integriert sind.

2. System nach Anspruch 1, dadurch gekennzeichnet, daß der Detektor ein Mosaik (16) aus Infrarot-Photodetektoren ist.

3. System nach Anspruch 1, dadurch gekennzeichnet, daß der Detektor durch eine lineare Anordnung (82) von Infrarot-Photodetektoren gebildet wird, und dadurch, daß das System außerdem optische Abtasteinrichtungen (87) dieser linearen Anordnung umfaßt.

4. System nach einem der Ansprüche 1 bis 3, dadurch gekennzeichnet, daß der Sender ein Mosaik (22) aus Infrarot-Photoemittern im sichtbaren oder nahen infraroten Bereich ist.

5. System nach einem der Ansprüche 1 bis 3, dadurch gekennzeichnet, daß der Sender durch eine lineare Anordnung (86) von Infrarot-Photoemittern gebildet wird, und dadurch, daß das System außerdem optische Abtasteinrichtungen (90) dieser linearen Anordnung umfaßt.

6. System nach einem der Ansprüche 1 bis 5, dadurch gekennzeichnet, daß der Detektor (16) und die Leseschaltung (18) hybrid zusammengefügt sind.

7. System nach einem der Ansprüche 1 bis 5, dadurch gekennzeichnet, daß der Detektor (16) und die Leseschaltung (18) monolithisch auf dem Substrat integriert sind.

8. System nach einem der Ansprüche 1 bis 7, dadurch gekennzeichnet, daß der Sender (22) und die Adressierungsschaltung (24) hybrid zusammengefügt sind, und dadurch, daß dieser Sender auf einem für das Licht dieses Senders durchlässigen Substrat (42) ausgebildet ist.

9. System nach einem der Ansprüche 1 bis 7, dadurch gekennzeichnet, daß der Sender (22) und die Adressierungsschaltung (24) hybrid zusammengefügt sind, daß dieser Sender auf einem Substrat (46) ausgebildet ist, das undurchlässig ist für das durch diesen Sender abgestrahlte Licht, und dadurch, daß dieses lichtundurchlässige Substrat den diesen Sender bildenden Photoemittern gegenüber Löcher (50) umfaßt, die den Durchgang des durch diesen Sender erzeugten Lichts ermöglichen.

10. System nach einem der Ansprüche 1 bis 7, dadurch gekennzeichnet, daß der Sender (22) und die Adressierungsschaltung (24) auf dem Substrat (26) monolithisch integriert sind.

11. System nach einem der Ansprüche 1 bis 10, dadurch gekennzeichnet, daß der Sender (22, 86) fähig ist, ein zum nahen infraroten Bereich gehörendes Licht zu erzeugen, und dadurch, daß das System außerdem Einrichtungen (36) zur Umwandlung dieses Lichts in sichtbares Licht umfaßt.
